# EUROPEAN PATENT SPECIFICATION

(11) **EP 2 436 030 B1**
(45) Date of publication and mention of the grant of the patent: **27.03.2013**
(21) Application number: 10726021.8
(22) Date of filing: 26.05.2010
(51) Int. Cl.: H01L 21/677

(54) **DEVICE FOR PARTICLE FREE HANDLING OF SUBSTRATES**
VORRICHTUNG ZUR PARTIKELFREIEN HANDHABUNG VON SUBSTRATEN
DISPOSITIF DE MANIPULATION DE SUBSTRATS SANS PARTICULES

(30) Priority: 28.05.2009 DE 102009022987; 27.08.2009 DE 102009038756
(43) Date of publication of application: 04.04.2012
(73) Proprietor: Semilev GmbH, 63868 Großwallstadt (DE)
(72) Inventor: AENIS, Martin, 64287 Darmstadt (DE); KLESEN, Christof, 64397 Modautal (DE); OLDENDORF, Ulrich, 64372 Ober-Ramstadt (DE); SEBALD, Thomas, 64289 Darmstadt (DE)
(74) Representative: Lippert, Stachow & Partner
(86) International application number: PCT/EP2010/057236
(87) International publication number: WO 2010/136488

(56) References cited:
- US-A- 5 397 212
- US-A1- 2008 181 758

## Description

The invention is concerned with a device for particle free handling of substrates according of micro technology within mini environments under clean room conditions, the device being adapted to transport a substrate along several axis with a handler which is provided with an electromagnetic movable fork on its free end, wherein the handler is supported on a vertical lift unit.

Since the application of the SMIF technology (Standard Mechanical Interface) for the handling of 200 mm wafers in the earlier nineties were silicon wafer in manufacturing of semiconductors no longer handled by persons but by robots. Thus each manufacturing machine is equipped with a so called factory interface respectively an EFEM (Equipment Front-End Module) which is arranged to open the transport cassettes with the wafers inside - "SMIF-pods for 200 mm and "FOUPS" (Front Opening Unified Pod) - at the machine, withdrawing the wafer and positioning of it within the production machine.

Thus the EFEM's underlie the highest purity standard like each production machine. In case of the 200 mm technology the design of the EFEM's was free selectable for the machine manufacturers, only the SMIF ports, this is the opening mechanism (SMIF loader) for the cassettes, was defined by the organisation SEMI (semi.org) and standardized worldwide. The used robotics and the design of the clean room engineering in the hand-over area between SMIF loader and machine access was something poorly conceived and was not in accordance with the necessary purity standard of the respective semiconductor technology.

Procedures for measuring and acceptance in view of the pureness of such small EFEM clean rooms, so called mini environments, was codified from SEMI in a standard "SEMI E44" in 1995 and 1996 to facilitate the manufacturers of machines to define the pureness of such systems.

Based on the experience in the SMIF technology the organisation SEMATECH (permatech.org) has published a guideline for the design of EFEM's (#99033693A-ENG, "Integrated Mini Environment Design Best Practices") with the initiation of 300 mm wafers in March 1999.

The construction of handling robots within the mini environments was not regulated in this documentation. Typically the robots are called also as handler. These are constructions for handling of silicon wafer with four degrees of freedom (linear x-, y-, z-axis and a rotational movement around the z-axis, the Φ-direction) which are used in such mini environments. Newly robots are used with a plurality of rotational axis because of the reason of the used area.

The robots are provided with bearings or slide bearings typically. The long linear movements at the base of the mini environment (typically called as y axis) pass mostly on conventional rolls or ball circular bearings and are driven by drive belts, steering racks or linear motors in best case.

The energy supply of such systems as well as signal cables and vacuum hoses if necessary must be carried by cables over drag chains respective energy cable drag chains.

All these mechanical components generate particles because of the friction which is not avoidable. In actual systems it is tried to keep off the generated particles from the critical wafer surface over a vertical movement of the air and exhaustion and encapsulation. Due to the turbulence and the "chaotic" behaviour of moved airflow at moved systems the effectiveness of such methods are limited in general. I.e. some parts of the generated particles reach the surface of the wafer at statistical view always.

With advanced miniaturization of structures and the enhancement of complexity of functions on the silicon wafer and especially with the next bigger wafer diameter of 450 mm the requirements in view of the pureness will be absolutely stronger. SEMATECH suggests in ITRS (International Technology Roadmap for Semiconductors) a refinement of the air quality at an ISP class1 (ISO Standard #14644).

The JP 04264749 discloses a transport robot at which the wafers are transported in a carriage through a tunnel by magnetic force whereby the carriage impends in the tunnel or impends below a handling device held by magnetic force. The transfer of the wafer into several transport roadways is handled by a transport robot. A similar transport system for wafers is described in the EP 0 626 724 B1.

The US 6 045 319 B and EP 0 246 098 B1 discloses also a magnetic transport system for the impending transport of carriages which can carry several articles. But there exist some additional guiding elements which can generate particles.

For the handling of wafers in such transport systems are used handlers for the handling of the wafers which realize a transport of the wafer in x-, y-, z- and Φ-direction.

In the JP 04267355 A is disclosed a wafer transport robot which can transport wafers in a vacuum chamber by a robot which is driven by magnets which are positioned outside the vacuum chamber.

In the US 5 288 199 is described a fixed positioned wafer handler which is provided with a magnetic drive for the linear movement. For that purpose the working arm is provided with a fork at one end which is moved in axial direction by an electromagnet. The pivotal bearing of the wafer handler is carried out conventional.

The US 5 397 212 A discloses a robot with dust-free and maintenance-free actuators with a vertical cylindrical casing with a robot arm which is linear actuable in a horizontal plane by a linear actuator. The actuator is fixedly supported on an outer rotor surrounding the cylindrical casing. The actuator is provided with a combination of electromagnets and permanent magnets to actuate the robot arm in linear direction and a rotary actuator to rotate the linear actuator. A screw shaft assembly as a vertical lift unit for vertical moving the rotary actuator within the outer rotor.

It is a task of the invention to provide a device for particle free handling of substrates of micro technology which works friction free.

The task is solved by a device according the invention which is designed with an electromagnetic linear bearing provided with an active component is supported in a passive component by lateral fastened magnetic bearings which held the active movable component on the passive component in balance and in abeyance whereby the active component is provided with the lift-rotary unit, which is provided with an outer tube fixed standing on the active component, within the outer tube are disposed in one or more levels magnetic bearings disposed regular on the inner circumferential surface of the outer tube to guide an inner tube contact less in vertical direction between two end positions.

A movable active unit is guided hanging over a magnetic bearing on the fix standing passive component, whereby a drive motor, disposed at the active component, is connected with an energy supply over a coupling unit and at the active component is disposed a lift-rotary unit with a handler.

The active component is provided with a drive motor arranged on it and which is designed as a linear motor.

On the active component is arranged an electromagnetic coupling device vis-à-vis to fixed coils at the passive component which are used as transmitting antenna to transfer energy to the active component.

The device is further provided with a central lift motor, which is disposed in the inner tube with a fixed standing coil arrangement and a magnetisable inner bar which is vertical disposable with the tube.

Within the inner tube is disposed an electromagnetic rotary drive also to effect a controllable rotation of the inner tube adverse to the inner bar.

Furthermore, the lift-rotary unit comprises four magnetic bearings at the inner circumferential surface of the outer tube arranged within one or more levels and disposed with an angular offset of each 90° between them to bear the inner tube without contact in vertical direction and which is movable supported between the two end positions.

The upper free end of the inner tube is used to hold further components like the handler to hold and transport wafers.

At the handler is disposed an electromagnetic movable fork to support a silicon wafer.

In addition, the handler is provided with a magnetic bearing and an electromagnetic drive to retract or pull out the fork.

According the invention comprise the frictionless the mechanical bearing of the several components as well as the energy and signal transmission to the several components.

The invention will be described on an example hereinafter. The respective drawings illustrate in
- Fig. 1:: a device according to the invention for particle free handling of substrates depicted in a cross section transverse to the driving direction with a fixed passive component, the active component is moved within the passive component whereby the good with the silicon wafers to be transported resides in the active component;
- Fig. 2:: a schematic side view of the device according Fig. 1 with the active component being in movement through the passive component;
- Fig. 3:: a device according to the invention for the particle free handling of substrates with standing active component shown in a sectional view transverse to the driving direction with moved passive component whereby the good with the silicon wafers to be transported resides in the passive component;
- Fig. 4:: a schematic depiction of the device according Fig. 3 with a passive component driving through active components being disposed with interspace;
- Fig. 5a-c:: the passive component during the run through active components in several positions;
- Fig. 6:: a sectional view of an electromagnetic linear-bearing as well as to drive a passive component within an active component according the invention;
- Fig. 7:: a sectional view of an electromagnetic lift-rotary bearing according the invention;
- Fig. 8:: a sectional side view of the lift-rotary bearing of Fig. 7 according the invention;
- Fig. 9:: a schematic sectional depiction of combination of a linear bearing and a rotary bearing with attached handler for silicon wafers in a lower position with a handler which is moved out;
- Fig. 10:: the device according to Fig. 9 with moved in handler in an upper position;
- Fig. 11:: details of the handler according to Fig. 10 with magnetic bearing and electromagnetic drive;
- Fig. 12:: the handler according to Fig. 11 in moved out position;
- Fig. 13:: a sectional view of the handler according view A of Fig. 12; and
- Fig. 14:: the view B of the handler according to Fig. 12.

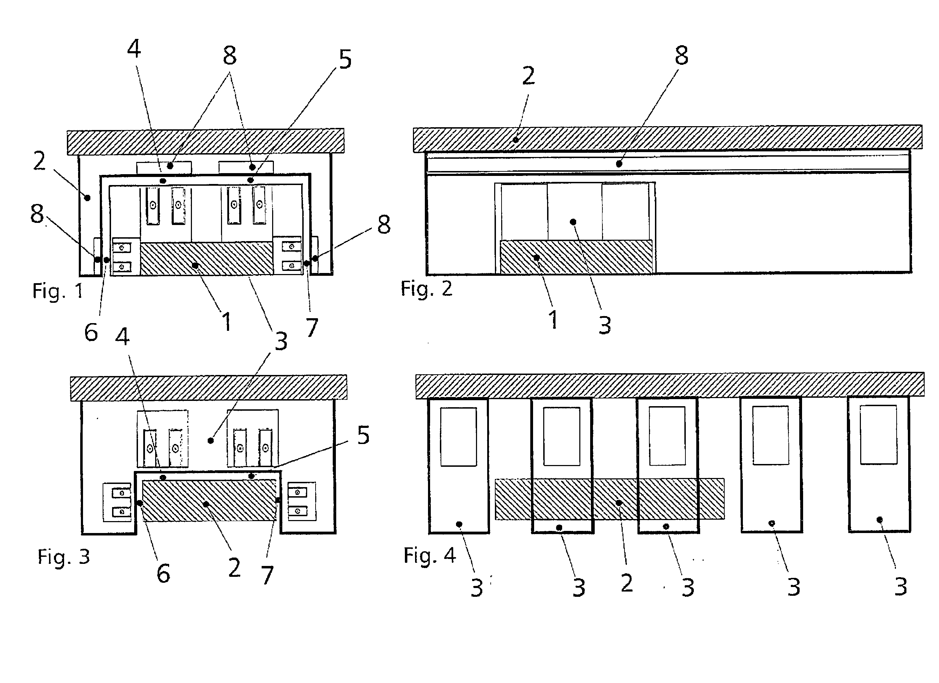

Fig. 1 illustrates a device for particle free handling of substrates (not shown) or other goods to be transported within a container 1 according the invention, which shows a sectional view transverse to the drive direction. The device consists of a fixed passive component 2, an active component 3 movable by magnetic force within along a planned trackway. Since the active component is moved it is necessary to provide it with energy for the magnetic bearing 4, 5 which held the active component below the passive component levitating. The energy supply is realized by an electromagnetic coupling device 6 which also powers the drive motor 7 with energy which is designed as a linear induction motor. The passive component 2 is provided with permanent magnets 8 only.

Fig. 2 illustrates the active component 3 during the drive along the passive component 2.

In Fig. 3 is shown a fixed active component 3 with moved passive component 2. The good with the silicon wafers to be transported resides in the transport container 1 which is the passive component 2 at the same time. To realize a drive of the passive component 2 in this embodiment, there are disposed some active components 3 disposed with interspace to one another along the planned trackway. Fig. 4 depicts a passive component 2 during the drive through some active components 3.

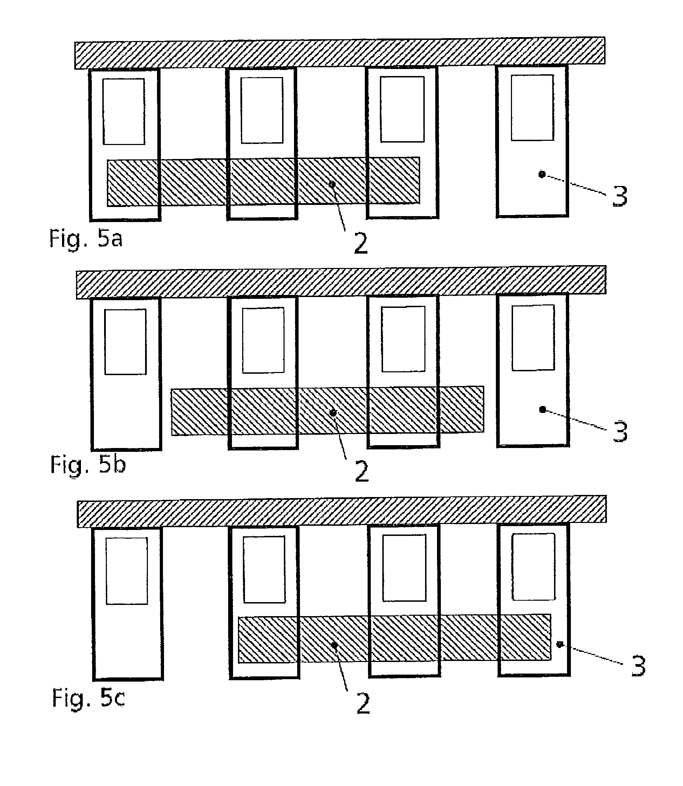

To guarantee a safe guiding of the passive component 2 it is to ensure that it will be held in abeyance always by at least two active components 3 during the drive (Fig. 5a - c).

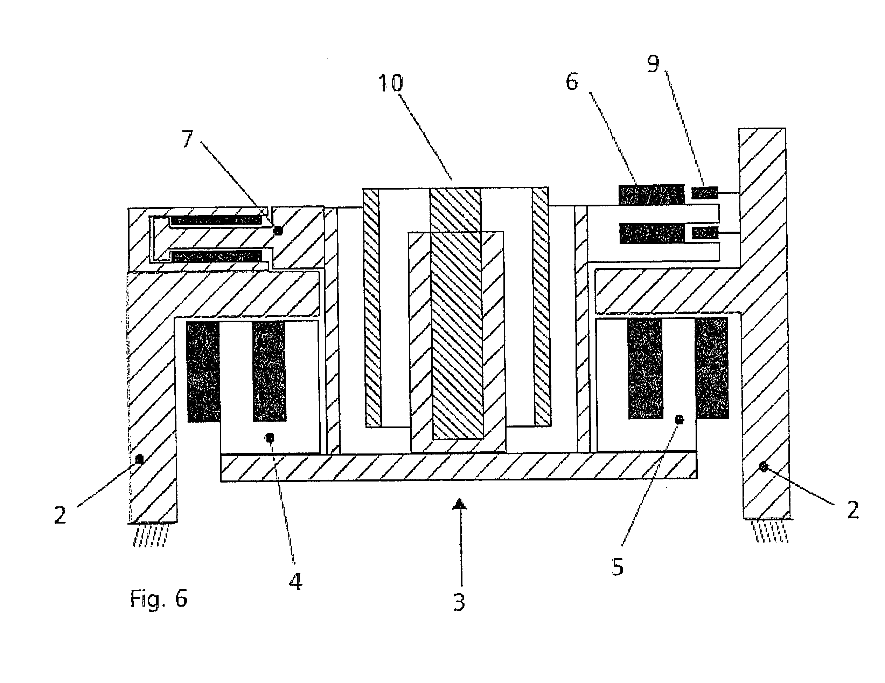

Fig. 6 shows a detailed sectional view of an electromagnetic linear bearing with an active component 3 supported in a passive component 2 according the invention.

To transfer energy to the active component there is arranged on the active component 3 an electromagnetic coupling device 6 vis-à-vis to fixed coils 9 at the passive component which are used as transmitting antenna. Furthermore there are disposed two lateral fastened magnetic bearings 4, 5 which held the active component 3 on the passive component 2 in balance and in abeyance.

The drive of the active component 3 is realized over the drive motor 7 arranged on it which is designed as a linear motor.

Furthermore the active component 3 is provided with a lift-rotary unit 10.

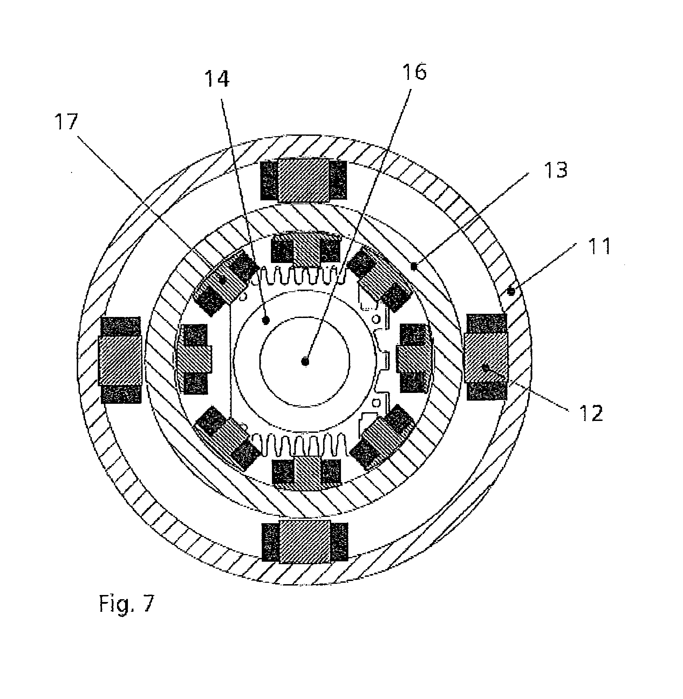

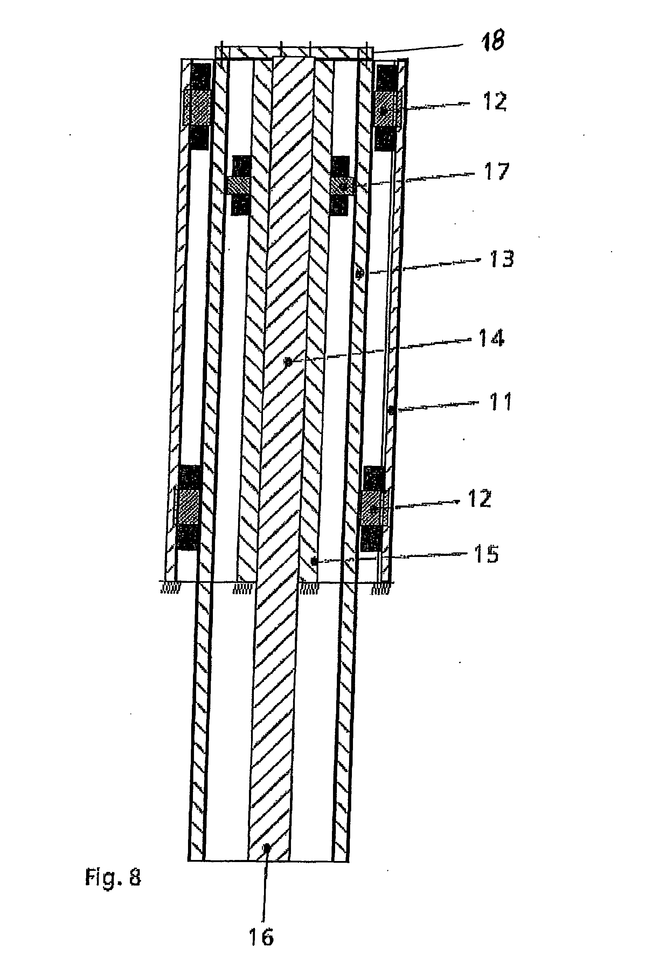

Figs. 7, 8 depict sectional views of such a lift-rotary unit. This lift-rotary unit comprises e.g. an outer tube 11 fixed standing on the active component 3 (Fig. 3) with four magnetic bearings 12 at the inner circumferential surface within one ore more levels disposed with an angular offset of each 90° between them to bear an inner tube 13 without contact in vertical direction and which is movable supported between two end positions.

To move the inner tube 13 in vertical direction is disposed a central lift motor 14 within of it with a fixed standing coil arrangement 15 and also a magnetisable bar 16 vertical disposable within the tube 13. The upper free end 18 of the inner tube 13 is used to hold further components like a handler 19 to hold and transport of wafers.

Furthermore is arranged a rotary drive 17 within the inner tube 13 (Fig. 7).

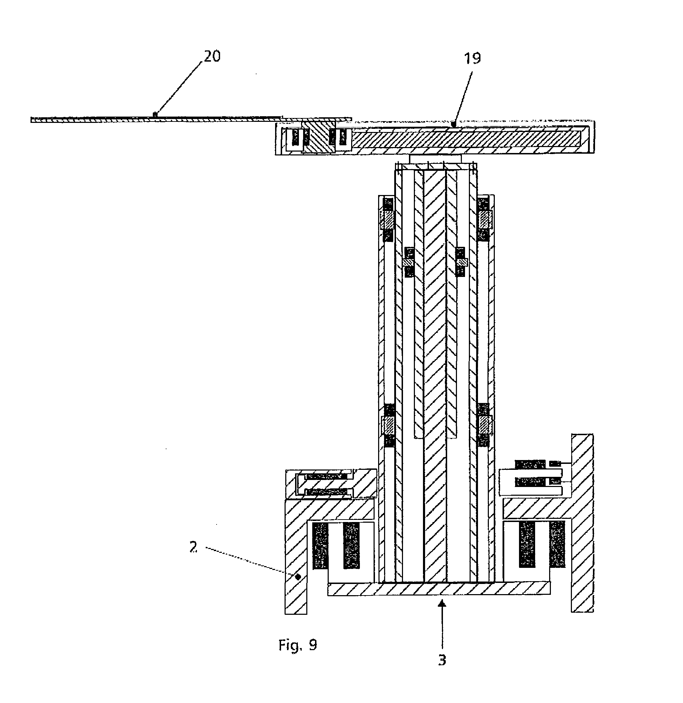

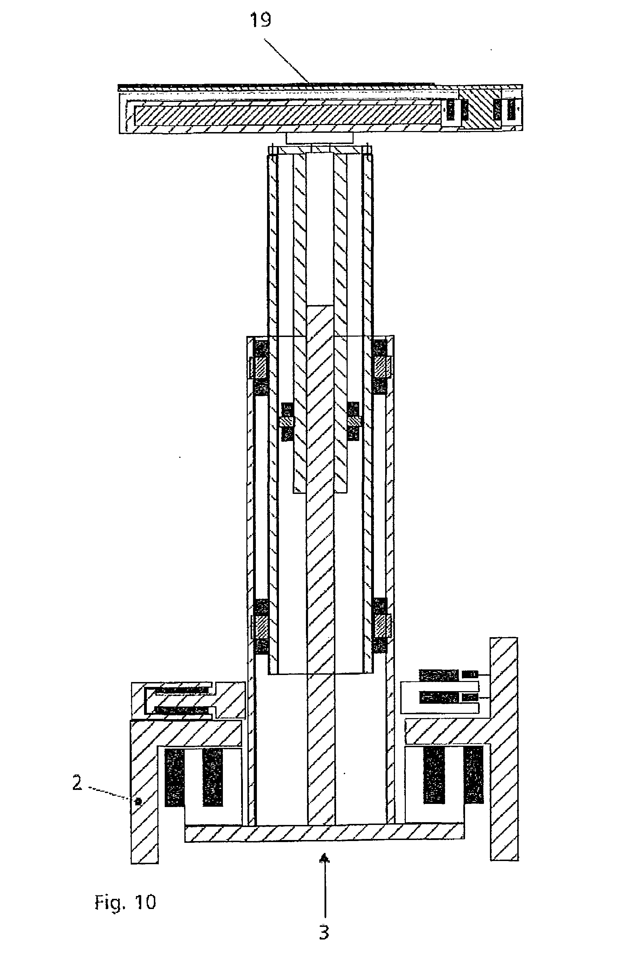

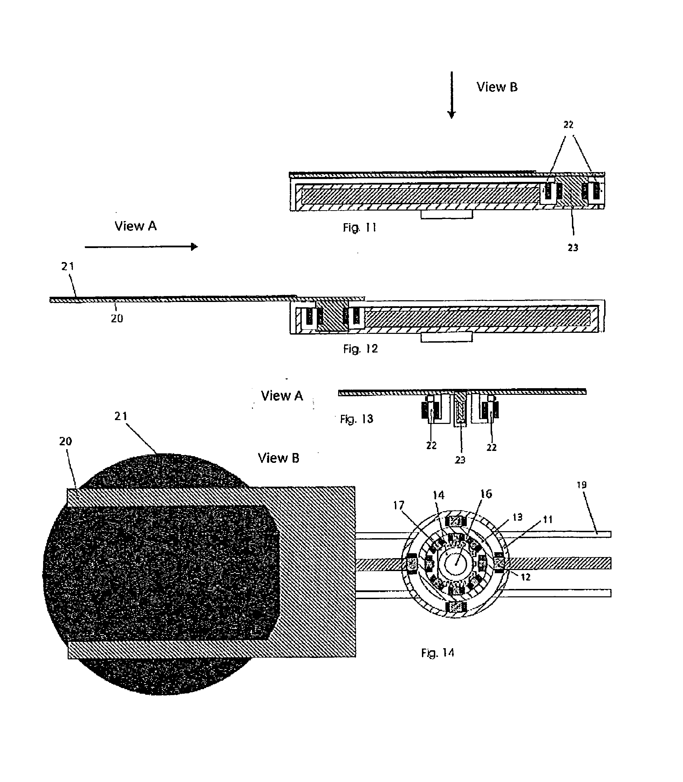

Fig. 9 shows a combination of a linear and rotary bearing according Fig. 7 with a attached handler 19 which is provided with an electromagnetic disposable fork 20 for carrying a silicon wafer 21 (Fig. 14). In Fig. 9 is the handler 19 shown with driven out fork 20 in a lower end position and in Fig. 10 in an upper end position with retracted fork 20. The handler 19 is also equipped with a contact free bearing and drive.

Details of the handler 19 are shown in Fig. 11 - 14, Fig. 11 shows the handler 19 according Fig. 10 with a magnetic bearing 22 and an electromagnetic drive 23 with retracted fork 20 (Fig. 11) and with pulled out fork 20 (Fig. 12).

Fig. 13 depicts a sectional view of the handler in a view A according Fig. 12 with a magnetic bearing 22 and the electromagnetic drive 23.

Fig. 14 depicts a view B of the handler according Fig. 12 with retracted fork 20 as well as the rotary drive according Fig. 7.

### DEVICE FOR PARTICLE FREE HANDLING OF SUBSTRATES

### LIST OF REFERENCE NUMBERS

- 1: transport container
- 2: passive component
- 3: active component
- 4: magnetic bearing
- 5: magnetic bearing
- 6: electromagnetic coupling device
- 7: drive motor
- 8: permanent magnet
- 9: coil
- 10: lift unit
- 11: outer tube
- 12: magnetic bearing
- 13: inner tube
- 14: lift motor
- 15: coil arrangement
- 16: magnetizable bar
- 17: rotary drive
- 18: free end
- 19: handler
- 20: fork
- 21: silicon wafer
- 22: magnetic bearing
- 23: electromagnetic drive

## Claims

1. Device for particle free handling of substrates of micro technology within mini environments under clean room conditions, the device being adapted to transport a substrate along several axis with a handler which is provided with an electromagnetic movable fork on its free end, wherein the handler is supported on a vertical lift rotary unit, **characterized in that** an electromagnetic linear bearing provided with an active component (3) is supported in a passive component (2) by lateral fastened magnetic bearings (4, 5) which held the active movable component (3) on the passive component (2) in balance and in abeyance whereby the active component (3) is provided with the lift-rotary unit (10), which is provided with an outer tube (11) fixed standing on the active component (3), within the outer tube (11) are disposed in one ore more levels magnetic bearings (12) disposed regular on the inner circumferential surface of the outer tube (11) to guide an inner tube (13) contact less and in vertical direction between two end positions.

2. Device according claim 1, **characterized in that** the movable active unit (3) is guided hanging over a magnetic bearing (4, 5) on the fix standing passive component (2), whereby a drive motor (7) disposed at the active component (3) is connected with an energy supply over a coupling unit (6) and whereby at the active component is disposed a lift-rotary unit (10) with a handler (19).

3. Device according claims 1 and 2, **characterized in that** the active component (3) is provided with a drive motor (7) arranged on it and which is designed as a linear motor.

4. Device according claims 1 to 3, **characterized in that** on the active component (3) is arranged an electromagnetic coupling device (6) vis-à-vis to fixed coils (9) at the passive component (2) which are used as transmitting antenna to transfer energy to the active component (3).

5. Device according to one of the claims 1 to 4, **characterized in that** a central lift motor (14) is disposed in the inner tube (13) with a fixed standing coil arrangement (15) and a magnetisable inner bar (16) which is vertical disposable within the tube (13).

6. Device according to claim 5, **characterized in that** an electromagnetic rotary drive (17) is disposed within the inner tube (13) to effect a controllable rotation of the inner tube (13) adverse to the bar (16).

7. Device according one of the claims 1 to 6, **characterized in that** the lift-rotary unit (10) comprises four magnetic bearings 12 at the inner circumferential surface of the outer tube (11) arranged within one ore more levels and disposed with an angular offset of each 90° between them to bear the inner tube (13) without contact in vertical direction and which is movable supported between the two end positions.

8. Device according to one of the claims 1 to 7, **characterized in that** the upper free end (18) of the inner tube (13) is used to hold further components like the handler (19) to hold and transport wafers (21).

9. Device according to one of the claims 1 to 8, **characterized in that** an electromagnetic movable fork (20) is disposed at the handler (19) to support a silicon wafer (20).

10. Device according to claim 9, **characterized in that** the handler (19) is provided with a magnetic bearing (22) and an electromagnetic drive (23) to retract or pull out the fork (20).

## Patentansprüche

1. Vorrichtung zur partikelfreien Handhabung von Substraten der Mikrotechnologie in Miniumgebungen unter Reinraumbedingungen, wobei die Vorrichtung eingerichtet ist, ein Substrat längs mehrerer Achsen mit einem Handhaber zu transportieren, der mit einer elektromagnetischen beweglichen Gabel an seinem freien Ende versehen ist, wobei der Handhaber an einer vertikalen Hebedreheinheit gehalten wird, **dadurch gekennzeichnet, dass** ein elektromagnetisches Linearlager, das mit einer aktiven Komponente (3) versehen ist, in einer passiven Komponente (2) durch lateral befestigte Magnetlager (4, 5) gehalten wird, die die aktive bewegliche Komponente (3) an der passiven Komponente (2) im Gleichgewicht und in der Schwebe halten, wobei die aktive Komponente (3) mit der Hebedreheinheit (10) versehen ist, die mit einem Außenrohr (11) versehen ist, das stehend an der aktiven Komponente (3) befestigt ist, wobei im Außenrohr (11) auf einer oder mehreren Ebenen Magnetlager (12) angeordnet sind, die regelmäßig an der Innenumfangsfläche des Außenrohrs (11) angeordnet sind, um ein Innenrohr (13) berührungslos und in vertikaler Richtung zwischen zwei Endpositionen zu führen.

2. Vorrichtung nach Anspruch 1, **dadurch gekennzeichnet, dass** die bewegliche aktive Einheit (3) über einem Magnetlager (4, 5) hängend an der festen stehenden passiven Komponente (2) geführt wird, wodurch ein an der aktiven Komponente (3) angeordneter Antriebsmotor (7) über eine Kopplungseinheit (6) mit einer Energieversorgung verbunden ist und wodurch an der aktiven Komponente eine Hebedreheinheit (10) mit einem Handhaber (19) angeordnet ist.

3. Vorrichtung nach Anspruch 1 und 2, **dadurch gekennzeichnet, dass** die aktive Komponente (3) mit einem an ihr angeordneten Antriebsmotor (7) versehen ist, der als ein Linearmotor gestaltet ist.

4. Vorrichtung nach Anspruch 1 bis 3, **dadurch gekennzeichnet, dass** an der aktiven Komponente (3) eine elektromagnetische Kopplungsvorrichtung (6) gegenüber festen Spulen (9) an der passiven Komponente (2) angeordnet ist, die als Sendeantenne verwendet werden, um Energie zur aktiven Komponente (3) zu übertragen.

5. Vorrichtung nach einem der Ansprüche 1 bis 4, **dadurch gekennzeichnet, dass** ein zentraler Hebemotor (14) im Innenrohr (13) mit einer festen stehenden Spulenanordnung (15) und einem magnetisierbaren inneren Stab (16) angeordnet ist, der im Rohr (13) vertikal verschiebbar ist.

6. Vorrichtung nach Anspruch 5, **dadurch gekennzeichnet, dass** ein elektromagnetischer Drehantrieb (17) im Innenrohr (13) angeordnet ist, um eine kontrollierbare Rotation des Innenrohrs (13) gegenüber dem Stab (16) zu bewirken.

7. Vorrichtung nach einem der Ansprüche 1 bis 6, **dadurch gekennzeichnet, dass** die Hebedreheinheit (10) vier Magnetlager (12) an der Innenumfangsfläche des Außenrohrs (11) aufweist, die auf einer oder mehreren Ebenen angeordnet sind und mit einem Winkelversatz von jeweils 90° zwischen ihnen angeordnet sind, um das Innenrohr (13) berührungslos in vertikale Richtung zu lagern, das zwischen den beiden Endpositionen beweglich gehalten wird.

8. Vorrichtung nach einem der Ansprüche 1 bis 7, **dadurch gekennzeichnet, dass** das obere freie Ende (18) des Innenrohrs (13) verwendet wird, um weitere Komponenten wie den Handhaber (19) zu halten, um Wafer (21) zu halten und zu transportieren.

9. Vorrichtung nach einem der Ansprüche 1 bis 8, **dadurch gekennzeichnet, dass** eine elektromagnetische bewegliche Gabel (20) am Handhaber (19) angeordnet ist, um einen Siliziumwafer (20) zu halten.

10. Vorrichtung nach Anspruch 9, **dadurch gekennzeichnet, dass** der Handhaber (19) mit einem Magnetlager (22) und einem elektromagnetischen Antrieb (23) versehen ist, um die Gabel (20) einzuziehen oder auszufahren.

## Revendications

1. Dispositif de manipulation de substrats sans particules conformément à une micro-technologie dans des mini-environnements en conditions de salle blanche, le dispositif étant conçu pour transporter un substrat le long de plusieurs axes avec un dispositif de manipulation pourvu d'une fourche amovible électromagnétique sur son extrémité libre, où le dispositif de manipulation est supporté sur une unité rotative de levage vertical, **caractérisé en ce qu'**un support linéaire électromagnétique pourvu d'un composant actif (3) est supporté dans un composant passif (2) par des supports magnétiques fixés latéralement (4, 5) qui maintiennent le composant actif mobile (3) en équilibre et en suspend sur le composant passif (2), moyennant quoi le composant actif (3) est pourvu d'une unité rotative de levage (10), qui est pourvue d'un tube externe (11) fixé d'aplomb sur le composant actif (3), à l'intérieur du tube externe (11) sont placés des supports magnétiques à un ou plusieurs niveaux (12) disposés de manière régulière sur la surface circonférentielle interne du tube externe (11) pour guider un tube interne (13) sans contact et suivant une direction verticale entre deux positions d'extrémité.

2. Dispositif selon la revendication 1, **caractérisé en ce que** l'unité active mobile (3) est guidée, suspendue au-dessus d'un support magnétique (4, 5), sur le composant passif d'aplomb fixe (2), moyennant quoi un moteur d'entraînement (7), placé au niveau du composant actif (3), est connecté à une alimentation en énergie par une unité de couplage (6) et moyennant quoi une unité rotative de levage (10) munie d'un dispositif de manipulation (19) est placée au niveau du composant actif.

3. Dispositif selon les revendications 1 et 2, **caractérisé en ce que** le composant actif (3) est pourvu d'un moteur d'entraînement (7) placé dessus, et qui a une conception de moteur linéaire.

4. Dispositif selon les revendications 1 à 3, **caractérisé en ce que**, sur le composant actif (3), est placé un dispositif de couplage électromagnétique (6), en vis-à-vis de bobines fixes (9) au niveau du composant passif (2), lesquels sont utilisées comme antennes de transmission pour transférer de l'énergie au composant actif (3).

5. Dispositif selon l'une des revendications 1 à 4, **caractérisé en ce qu'**un moteur de levage central (14) est placé dans le tube interne (13) avec un arrangement de bobine fixé d'aplomb (15) et d'une barre interne magnétisable (16) qui peut être placée verticalement à l'intérieur du tube (13).

6. Dispositif selon revendication 5, **caractérisé en ce qu'**un moteur rotatif électromagnétique (17) est placé à l'intérieur du tube interne (13) afin d'effectuer une rotation contrôlable du tube interne (13) dans le sens inverse de la barre (16).

7. Dispositif selon l'une des revendications 1 à 6, **caractérisé en ce que** l'unité rotative de levage (10) comprend quatre supports magnétiques 12 au niveau de la surface circonférentielle interne du tube externe (11) disposés à l'intérieur d'un ou plusieurs niveaux et placés avec un décalage angulaire de 90° entre chacun d'eux pour supporter le tube interne (13) sans contact suivant la direction verticale, et est supportée de manière mobile entre les deux positions d'extrémité.

8. Dispositif selon l'une des revendications 1 à 7, **caractérisé en ce que** l'extrémité libre supérieure (18) du tube interne (13) est utilisée pour maintenir des composants supplémentaires tels que le dispositif de manipulation (19) afin de tenir et transporter des plaquettes (21).

9. Dispositif selon l'une des revendications 1 à 8, **caractérisé en ce qu'**une fourche amovible électromagnétique (20) est placée au niveau du dispositif de manipulation (19) pour supporter une plaquette de silicium (20).

10. Dispositif selon la revendication 9, **caractérisé en ce que** le dispositif de manipulation (19) est pourvu d'un support magnétique (22) et d'un moteur électromagnétique (23) pour rétracter ou retirer la fourche (20).
